Europäisches Patentamt

European Patent Office

Office européen des brevets

(11) Veröffentlichungsnummer: **0 440 264 A1**

## (12) EUROPÄISCHE PATENTANMELDUNG

(21) Anmeldenummer: 91103311.6

(22) Anmeldetag: 22.10.88

(51) Int. Cl.5: **B23K 1/08**, B23K 1/00, //H05K3/34

Diese Anmeldung is am 05 - 03 - 1991 als Teilanmeldung zu der unter INID-Kode 60 erwähnten Anmeldung eingereicht worden.

(30) Priorität: 05.11.87 DE 3737563

(43) Veröffentlichungstag der Anmeldung: 07.08.91 Patentblatt 91/32

(60) Veröffentlichungsnummer der früheren Anmeldung nach Art. 76 EPÜ: 0 315 000

(84) Benannte Vertragsstaaten: AT BE CH DE ES FR GB IT LI NL SE

(71) Anmelder: **Hohnerlein, Ernst Ringstrasse 7 W-6983 Kreuzwertheim(DE)**

(72) Erfinder: **Hohnerlein, Ernst Ringstrasse 7 W-6983 Kreuzwertheim(DE)**

(74) Vertreter: **Schieferdecker, Lutz, Dipl.-Ing. Herrnstrasse 37 W-6050 Offenbach am Main(DE)**

(54) **Verfahren und Vorrichtung zum Löten unter Schutzgas.**

(57) Die Erfindung betrifft ein Verfahren und eine Vorrichtung zum Herstellen einer sauerstoff-freien Atmosphäre beim Löten von elektronischen Bauteilen unter Schutzgas in einer Lötvorrichtung, die eine mehrteilige Tunnelanordnung (1) mit einer eine Löteinrichtung (23) aufweisenden Lötstrecke (27) umfaßt.

Der Kern der Erfindung besteht darin, daß die Tunnelelemente bei Verwendung eines Schutzgases, welches leichter ist als Luft, derart geneigt angeordnet werden, daß eingedrungene Luft sich an den tieferliegenden Stellen der Tunnelanordnung ansammelt, wobei der Austrittstunnel (4) in Transportrichtung der elektronischen Bauteile fallend angeordnet ist.

Fig. 1

## VERFAHREN UND VORRICHTUNG ZUM LÖTEN UNTER SCHUTZGAS

Die Erfindung betrifft ein Verfahren und eine Vorrichtung zum Herstellen einer sauerstoff-freien Atmosphäre beim Löten von elektronischen Bauteilen unter Schutzgas in einer Lötvorrichtung, die eine mehrteilige Tunnelanordnung mit einer eine Löteinrichtung aufweisenden Lötstrecke umfaßt.

Eine Vorrichtung der genannten Art ist z.B. aus dem DE-GM 85 20 254 bekannt. Bei dieser Lötvorrichtung wird eine sauerstoff-freie Lötstrecke angestrebt, wozu das die Lötstrecke enthaltende Gehäuse mit Schutzgas gefüllt wird. Im Abstand vor und hinter dem Gehäuse mit der Lötstrecke bebefinden sich Schleusen, um das Innere der Lötkammer gegenüber der Außenluft hermetisch abzuschließen. Eine Gemischbildung von Schutzgas und Außenluft in der Lötkammer soll dadurch verhindert werden. Um dies zu erreichen, ist bei der bekannten Vorrichtung ferner vorgesehen, daß die Luft aus den Schleusenkammern nach jedem Durchgang von Bauteilen abgesaugt wird, damit nicht atmosphärischer Sauerstoff in das Innere der Lötkammer gelangt. Der hiermit verbundene Aufwand ist außerordentlich groß und nicht nur mit einem hohen Energieaufwand verbunden, sondern auch zeitaufwendig.

Der Erfindung liegt daher das Problem zugrunde, eine Lötvorrichtung der genannten Art so zu gestalten, daß die Lötstrecke auch bei wesentlich geringerem Aufwand möglichst sauerstoff-frei ist, daß ohne Vakuum gearbeitet werden kann und daß sich auch der Verbrauch an Schutzgas möglichst gering halten lässt.

Zur Lösung dieser Aufgabe sieht die Erfindung vor, daß die Tunnelelemente bei Verwendung eines Schutzgases, welches leichter ist als Luft, derart geneigt angeordnet werden, daß eingedrungene Luft sich an den tieferliegenden Stellen der Tunnelanordnung ansammelt, wobei der Austrittstunnel in Transportrichtung der elektronischen Bauteile fallend angeordnet ist.

Bereits hiermit lässt sich eine in hohem Maße sauerstofffreie Lötzone mit geringem Aufwand schaffen, wobei durch die Neigung der Tunnelelemente nicht mehr eine derart komplizierte Kapselung der Tunnelelemente wie beim Stand der Technik und auch nicht mehr Schleusenkammern mit eigenen Fördervorrichtungen erforderlich sind. Ferner muß auch nicht mehr mit Vakuum gearbeitet werden. Es genügen einfache Dichtungsklappen, um eine sauerstoff-freie Lötstrecke zu schaffen, wenn der Unterschied zwischen dem spezifischen Gewicht von Schutzgas und Luft durch die Gestaltung der Tunnelanordnung ausgenutzt wird.

Eine wesentliche Verringerung des Schutzgasverbrauchs wird in Weiterbildung der Erfindung dadurch erzielt, daß die Tunnelelemente einen geringen lichten Querschnitt in vertikaler Richtung aufweisen.

Auch ist es zweckmässig, wenn der Löttunnel mit der Fördervorrichtung für die elektronischen Bauteile gemäß der Erfindung in Förderrichtung steigend angeordnet ist, wobei sich dann der Eintrittstunnel oder ein Teil von diesem zum Löttunnel hin fallend erstreckt.

Weitere Merkmale der Erfindung gehen aus Unteransprüchen im Zusammenhang mit der Beschreibung und der Zeichnung hervor.

Die Erfindung wird nachstehend anhand eines Ausführungsbeispieles, das in der Zeichnung dargestellt ist, näher beschrieben. Dabei zeigen:

Fig. 1     eine teilweise geschnittene Seitenansicht der Lötvorrichtung;
Fig. 2     eine Draufsicht auf die Lötvorrichtung gemäß Fig. 1
Fig. 3     einen vergrößerten Ausschnitt aus Fig. 1;
Fig. 4     einen Schnitt längs Linie IV-IV in Fig. 1 und
Fig. 5     ein Wechselaggregat für die Reduktionsmittelzufuhr in Seitenansicht.

Die Lötvorrichtung weist ein in den Figuren nicht dargestelltes Maschinengestell, Antriebe und Versorgungseinrichtungen auf, die grundsätzlich bekannt sind. Als wesentliches Bauteil weist die Vorrichtung eine langgestreckte Tunnelanordnung 1 auf, die einen Eintrittstunnel 2, einen Löttunnel 3 und einen Austrittstunnel 4 umfaßt. Der Eintrittstunnel 2 ist in zwei Tunnelabschnitte 5 und 6 unterteilt, von denen der Tunnelabschnitt 5 den Eingangsabschnitt bildet. Die Tunnelabschnitte 5 und 6 sind ebenso wie die Tunnel 2, 3 und 4 durch biegsame Bälge 7, 8 und 9 miteinander verbunden.

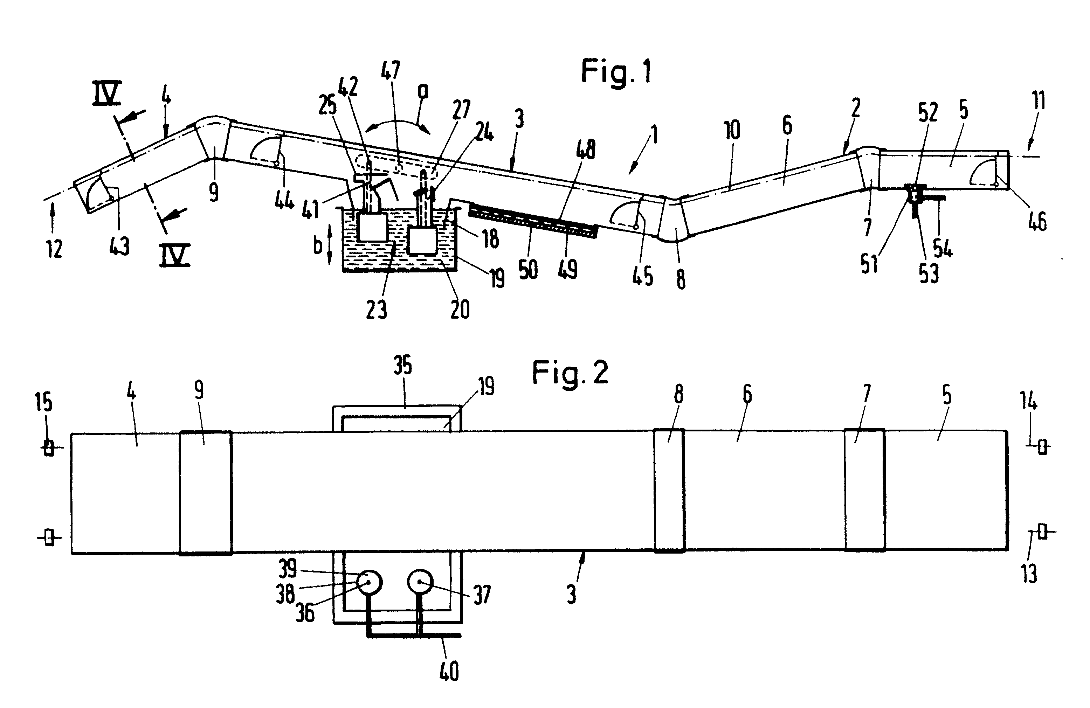

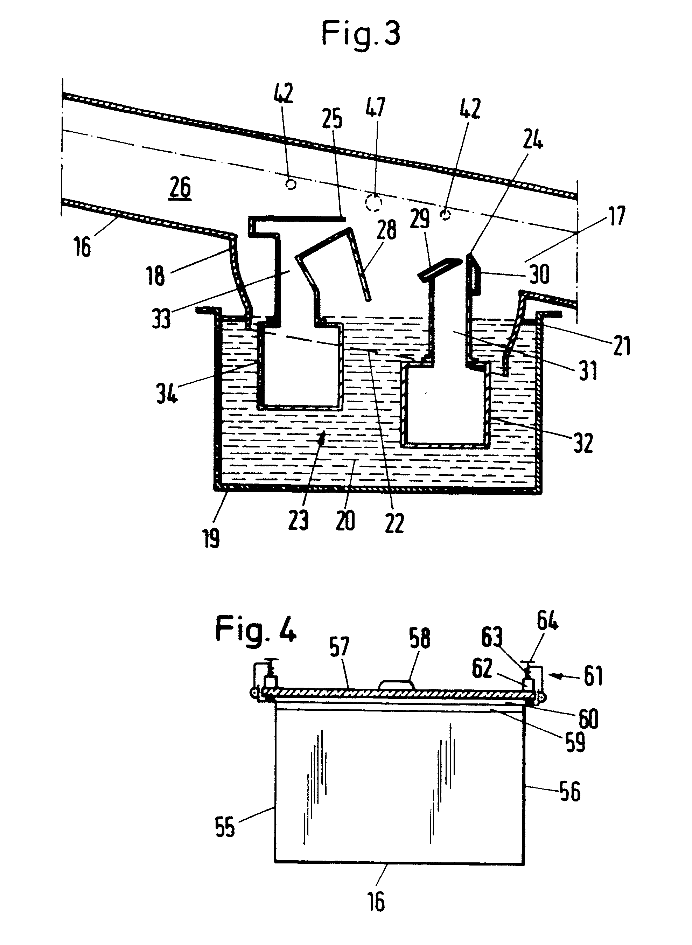

Durch die Tunnelanordnung erstreckt sich eine Fördervorrichtung 10, die in Fig. 1 nur strichpunktiert mit der Förderbahn angedeutet ist. Die Fördervorrichtung 10 erstreckt sich an beiden Enden über die Tunnelanordnung 1 hinaus und bildet dabei eine Beschickungsstation 11 und eine Entnahmestation 12 zum Einhängen bzw. zum Entnehmen der Werkstücke wie Leiterplatten, an denen Lötungen vorgenommen werden sollen. Entsprechend der Durchlaufrichtung der Werkstücke in Fig. 1 von rechts nach linke sind der Tunnelabschnitt 5 im wesentlichen horizontal, der Tunnelabschnitt 6 in Förderrichtung fallend, der Löttunnel 3 in Förderrichtung ansteigend und der Austrittstunnel 4 in Förderrichtung wieder fallend angeordnet. Die Fördervorrichtung 10 erstreckt sich in entsprechender Weise längs einer abgewinkelten Bahn. Wie Fig. 2 zeigt weist die Fördervorrichtung 10 zwei parallele seitliche Fördertrume 13 und 14 auf, an denen aufeinander ausgerichtete Halterungen 15 angeordnet sind, mit denen die Werkstücke bzw. Leiterplatten an gegenüberliegenden Seiten festgeklemmt werden können, so daß sie an der Fördervorrichtung 10 aufgehängt sind und mit dieser durch die Tunnelanordnung 1 transportiert werden. Diese weist auf ihrer ganzen Länge einen im wesentlichen rechteckigen Querschnitt von vergleichsweise geringer Höhe auf, wie es Fig. 4 zeigt.

Wie insbesondere aus Fig. 3 zu ersehen, weist der Tunnelboden 16 des Löttunnels 3 in einem mittleren Längenbereich eine Bodenöffnung 17 auf, die von einer herabragenden Dichtungsschürze 18 umgeben ist. Unterhalb der Bodenöffnung 17 ist eine Wanne 19 angeordnet, die mit einer nicht dargestellten Heizeinrichtung versehen ist und das Schmelzbad aus dem verflüssigten Lötmittel 20 aufnimmt. Wie dargestellt, taucht die Dichtungsschürze 18 durch den Badspiegel 21 hindurch in das verflüssigte Lötmittel 20 ein, eo daß der untere Schürzenrand 22 vollständig unterhalb des Badspiegels 21 angeordnet ist.

Zum Aufbringen dem Lots auf die schräg abwärts weisende Unterseite der Werkstücke ist eine Löteinrichtung 23 mit wenigstens einer Lötdüse vorgesehen. Beim dargestellten Ausführungsbeispiel sind zwei Lötdüsen 24 und 25 vorhanden, die einen sich horizontal und quer zum Löttunnel 3 erstreckenden Düsenschlitz aufweisen. Die Lötdüsen 24 und 25 sind von unterschiedlicher Ausbildung und Ausrichtung, wobei die Lötdüse 24 als Auftragsdüse und die in Transportrichtung nachfolgende Lötdüse 25 als Abstreifdüse wirkt. Die Düsen 24 und 25 sind innerhalb der vom Löttunnel 3 umschlossenen Lötkammer 26 oberhalb des Badspiegels 21 angeordnet. Sie bestimmen die in Fig. 1 eingezeichnete Lötzone oder Lötstrecke 27. Während die Lötdüse 25 ein zum Badspiegel 21 hin geneigtes Ablaufblech 28 aufweist, ist die Lötdüse 24 mit Leitblechen 29 und 30 versehen. Die Lötdüse 24 ist über einen durch den Badspiegel 21 ragenden Steigkanal 31 mit einem sich innerhalb der Wanne 19 in Querrichtung erstreckenden Versorgungskanal 32 verbunden. In entsprechender Weise sind der Lötdüse 25 ein Steigkanal 33 und ein Versorgungskanal 34 zugeordnet.

Wie aus Fig. 2 zu ersehen, erstreckt sich die innerhalb eines Isoliermantels 35 angeordnete Wanne 19 quer zum Löttunnel 3 und ragt im wesentlichen auf einer Seite über diesen vor. Dort ist jedem Versorgungskanal 32 und 34 eine eigene Umwälzpumpe zugeordnet, deren Betrieb dazu führt, daß aus beiden Lötdüsen 24 und 25 jeweils ein Schwall des flüssigen Lötmittels austritt, der mit der Unterseite der durch die Fördervorrichtung 10 vorbei transportierten Werkstücke in Kontakt tritt. In Fig. 2 sind von diesen Pumpen nur die beiden Antriebswellen 36 und 37 zu sehen, die sich senkrecht durch den Badspiegel 21 erstrecken, an ihrem oberen Ende mit einem Antriebsmotor versehen sind und an ihrem unteren Ende ein Pumprad tragen. Jede Antriebswelle 36 und 37 ist mit einem umgekehrt becherförmigen Topf 38 versehen, dessen nach oben weisender Topfboden 39 gasdicht von der Antriebswelle 36 bzw.37 durchdrungen ist und dessen herabragender zylindrischer Rand wie die Dichtungsschürze 18 in des flüssige Lötmittel 20 eintaucht. Über eine Stickstoffleitung 40 werden beide Töpfe 38 mit Stickstoff versorgt, so daß sich in ihnen keine Luft und damit kein Sauerstoff mehr befindet. Auf diese Weise wird verhindert, daß Luft entlang da Antriebswellen 36 und 37 in das Lötmittel 20 eindringt und zu den Lötdüsen 24 bzw. 25 gepumpt wird. Außerdem wird dem in Gegenwart von Sauerstoff stark korrodierenden Angriff des heißflüssigen Lötmittels 20 auf die Antriebswellen vorgebeugt.

Zwei weitere Schutzgasleitungen 41,durch die Stickstoff unter geringem Überdruck durch Austrittsöffnungen 42 (Fig. 3) in die Lötkammer 26 ausströmt, sind in Fig. 1 angedeutet. Der zugeführte Stickstoff füllt die gesamte Tunnelanordnung 1 einschließlich des von der Dichtungsschürze 18 umschlossenen Raums oberhalb des Badspiegels 21 und verhindert somit den Zutritt von Luft zur Lötstrecke 27. Um dem Ausströmen von Stickstoff aus der Tunnelanordnung und einer Vermischung mit Luft vorzubeugen, sind wie in Fig. 1 angedeutet vier den Tunnelquerschnitt im wesentlichen verschließende Dichtungsklappen 43, 44, 45 und 46 vorgesehen, die von passierenden Werkstücken bzw. der Fördervorrichtung 10 in Transportrichtung aufgeklappt werden und sich danach wieder schließen. Mit den vorstehend beschriebenen Maßnahmen gelingt es, den Sauerstoffanteil im Bereich der Lötstrecke 27 unter 3 ppm zu halten, was für eine hohe Lötqualität wesentlich ist.

Der Löttunnel 3 ist mittels einer nicht dargestellten Verstellvorrichtung um eine horizontale Querachse 47 schwenkbar, wie dieses in Fig. 1 durch den Doppelbogenpfeil a angedeutet ist. Auf diese Weise kann die Neigung des Löttunnels 3 und damit auch die Schrägstellung der durch den Löttunnel 3 transportierten Werkstücke den jeweiligen Gegebenheiten angepaßt werden. Die Neigungsänderung ist problemlos durchführbar, weil die Bälge 7, 8 und 9 Stellungsveränderungen der Tunnelanordnung 1 aufnehmen und weil die in das flüssige Lötmittel 20 eintauchende Dichtungsschürze Gewähr dafür bietet, daß trotz einer Relativbewegung zwischen dem Löttunnel 3 und der Wanne 19 keine Luft in die Lötkammer 26 eindringt. Aus diesem Grunde ist auch eine einfache Höhenverstellung der Wanne 19 mittels einer nicht dargestellten Verstelleinrichtung entsprechend dem Doppelpfeil b in Fig. 1 möglich, wodurch die Lötdüsen 24 und 25 in eine gegenüber der Transportbahn der Fördervorrichtung 10 bzw. gegenüber den passierenden Werkstük-

ken zweckmäßige Stellung gebracht werden können.

Wie aus Fig. 1 zu ersehen ist im Tunnelboden 16 des Löttunnels 3 in Transportrichtung vor der Dichtungsschürze 18 eine Glaskeramikplatte 48 eingebaut, an deren Unterseite elektrische Heizstäbe 49 angeordnet sind, die nach unten durch eine Isolierung 50 abgeschirmt sind. Mittels der Heizstäbe 49 werden die durch den Löttunnel 3 vorbewegten Werkstücke soweit vorgewärmt, daß Beschädigungen durch eine plötzliche Temperaturerhöhung im Bereich der Lötstrecke 27 vermieden werden.

Zum Aufbringen eines Flußmittels auf die Unterseiten der Werkstücke ist im Boden des Tunnelabschnitts 5 gemäß Fig. 1 eine Sprüheinrichtung 51 mit einer Ultraschall-Zerstäuberdüse 52 angeordnet. Diese Sprüheinrichtung ist in der gleichzeitig unter der Bezeichnung "Verfahren und Vorrichtung zum Auftragen eines Flußmittels" eingereichten Patentanmeldung näher beschrieben. Die Ultraschall-Zerstäuberdüse 52 zerstäubt über eine Speiseleitung 53 im wesentlichen drucklos zugeführtes Flußmittel, das üblicherweise natürliche oder modifizierte Harze mit Zusätzen einschließlich einer Säure enthält und reduzierend auf die zu verlötenden Metalloberflächen einwirkt. Es ist vorgesehen, anstelle des bisher schaumförmig aufgebrachten und zu starken Verschmierungen der Vorrichtung führenden Flußmittels reine Adipinsäure ohne Zusätze aufzubringen, das als Pulver mit 1 % in Äthylalkohol gelöst in dünnflüssiger Form durch die Ultraschall-Zerstäuberdüse 52 vernebelt wird und durch einen den Nebel ringförmig umschließenden Luftstrom gezielt auf die Werkstückunterseite aufgebracht wird. Dazu ist an die Sprüheinrichtung 51 eine Druckluftleitung 54 angeschlossen.

Die aus Fig. 4 zu ersehende Tunnelausbildung gilt im wesentlichen unverändert für die gesamte Tunnelanordnung 1 bzw. die Tunnel 2, 3 und 4. Danach weist der bzw. jeder Tunnel einen Boden 16 und zwei von diesem aufragende Tunnelwände 55 und 56 auf, die vorzugsweise aus Leichtmetall bestehen. Die Tunneloberseite wird im wesentlichen von einer Reihe von abnehmbaren Sichtglasplatten 57 gebildet, die eine handliche Länge in Erstreckungsrichtung der Tunnelanordnung 1 aufweisen und an ihren Schmalseiten mit einem Griff 58 versehen sind. An der Stoßstelle zwischen benachbarten Sichtglasplatten sind die Tunnelwände 55 und 56 durch Querstege 59 miteinander verbunden, die zusammen mit den oberen Randbereichen der Tunnelwände 55 und 56 eine umlaufende Auflagefläche bilden, an welche die Sichtglasplatte 57 unter Zwischenfügung eines geschlossenen Dichtstreifens 60 abdichtend angedrückt ist. Dazu sind auf beiden Tunnelseiten in Abständen Schnellarretierungen verschwenkbar am oberen Rand der Tunnelwand 55 bzw. 56 angelenkt. Jede Schnellarretierung 61 weist ein Druckstück 62 auf, das in der dargestellten Betriebsstellung mittels einer Feder 63 die Sichtglasplatte 57 gegen den Dichtstreifen 60 drückt. Durch einen Lösegriff 64 kann das Druckstück entgegen der Federkraft hochgezogen und die Schnellarretierung 61 seitlich weggeschwenkt werden. Als Sichtglasplatten 57 sind Platten aus Sicherheitsglas (Drahtglas) vorgesehen. Im Bereich der Lötstrecke 27 und auch im Bereich der Heizstäbe 49 sind Sichtglasplatten aus temperaturbeständiger Glaskeramik vorgesehen. Diese Maßnahmen ermöglichen eine optische Kontrolle längs der gesamten Tunnelanordnung 1 und insbesondere auch im Bereich der Lötstrecke 27 sowie erforderlichenfalls einen schnellen Zugang an jeder Stelle der Tunnelanordnung 1 durch Entfernen der betreffenden Sichtglasplatte 57. Die einzelnen Sichtglasplatten 57 und Schnellarretierungen 61 sind in den Figuren 1 und 2 nicht dargestellt.

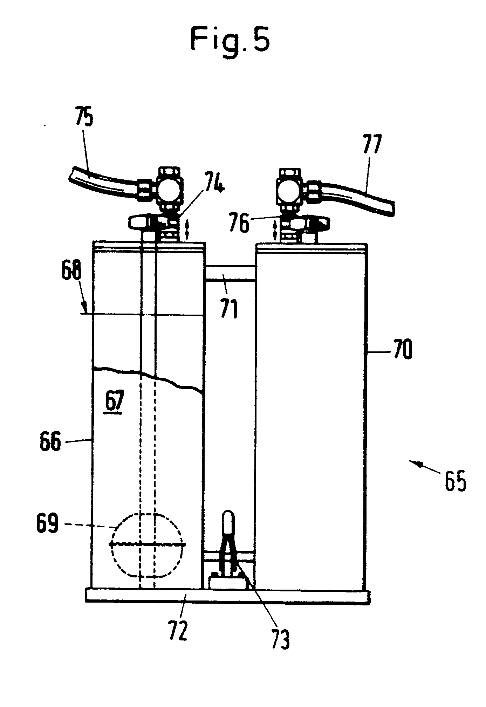

Trotz der weitgehenden Sicherheit, mit der durch die vorbeschriebenen Maßnahmen Luft und damit Luftsauerstoff von der Lötstrecke 27 ferngehalten wird, kann vorsorglich dem Schutzgas (Stickstoff) noch ein Reduktionsmittel zugesetzt werden. Zweckmäßigerweise wird dazu eine exakt dosierbare Teilmenge des der Lötkammer 26 über die Schutzgasleitung 41 zugeführten Stickstoffs abgezweigt und mit reduzierend wirkender Ameisensäure in gasförmiger Form beladen. Eine dafür verwendbare Anreicherungseinrichtung 65 ist in Fig.5 dargestellt. Die Anreicherungseinrichtung 65, die an grundsätzlich beliebiger Stelle der Vorrichtung angeordnet werden kann, weist einen Reduziermittelbehälter 66 mit einer Nachfüllkammer 67 für die flüssige Ameisensäure auf, deren maximaler Füllstand mit 68 angedeutet ist. Eine Schwimmerkugel 69 signalisiert das Erreichen des minimalen Füllstandes und damit die Notwendigkeit zum Behälterwechsel bzw. zum Nachfüllen von Ameisensäure. Dem Reduziermittelbehälter 66 ist ein Tropfenabscheidebehälter 70 zugeordnet. Die Behälter 66 und 70 sind durch eine Überströmleitung 71 verbunden und durch eine Halterung 72 zu einem Aggregat verbunden, das mittels eines Schnellverschlusses 73 montiert und gelöst wird, um gegen ein entsprechendes nachgefülltes Aggregat ausgetauscht zu werden. Das kann bei kurzzeitiger Abschaltung der Stickstoffzufuhr ohne Unterbrechung des Lötbetriebs geschehen. Dazu sind noch die Schnellverschraubung 74 zwischen der Stickstoffzuleitung 75 und dem Reduziermittelbehälter 66 sowie die Schnellverschraubung 76 zwischen dem Tropfenabscheidebehälter 70 und der Stickstoffableitung 77 zu lösen und nach dem Aggregatwechsel wieder anzuschrauben. Es hat sich gezeigt, daß ein Durchströmen der Anreicherungseinrichtung 65 mit einem geringen Stickstoffdurchsatz von beispielsweise 5 l/min genügt, um eine ausreichende Menge an gasförmig aufgenommener Ameisensäure der Lötkammer 26 zuzuführen.

Bezugszeichenliste

| | |
|---|---|
| 1 Tunnelanordnung | 41 Schutzgasleitung |
| 2 Eintrittstunnel | 42 Austrittsöffnung |
| 3 Löttunnel | 43 Dichtungsklappe |
| 4 Austrittstunnel | 44 Dichtungsklappe |
| 5 Tunnelabschnitt | 45 Dichtungsklappe |
| 6 Tunnelabschnitt | 46 Dichtungsklappe |
| 7 Balg | 47 Querachse |
| 8 Balg | 48 Glaskeramikplatte |
| 9 Balg | 49 Heizstab |
| 10 Fördervorrichtung | 50 Isolierung |
| 11 Beschickungsstation | 51 Sprüheinrichtung |
| 12 Entnahmestation | 52 Ultraschall-Zerstäuber- |
| 13 Fördertrum | düse |
| 14 Fördertrum | 53 Speiseleitung |
| 15 Halterung | 54 Druckluftleitung |
| 16 Tunnelboden | 55 Tunnelwand |
| 17 Bodenöffnung | 56 Tunnelwand |
| 18 Dichtungsschürze | 57 Sichtglasplatte |
| 19 Wanne | 58 Griff |
| 20 Lötmittel, Schmelzbad | 59 Quersteg |
| 21 Badspiegel | 60 Dichtstreifen |
| 22 Schürzenrand | 61 Schnellarretierung |
| 23 Löteinrichtung | 62 Druckstück |
| 24 Lötdüse | 63 Feder |
| 25 Lötdüse | 64 Lösegriff |
| 26 Lötkammer | 65 Anreicherungseinrichtung |
| 27 Lötstrecke | 66 Reduziermittelbehälter |
| 28 Ablaufblech | 67 Nachfüllkammer |
| 29 Leitblech | 68 maximaler Füllstand |
| 30 Leitblech | 69 Schwimmerkugel |
| 31 Steigkanal | 70 Tropfenabscheidebehälter |
| 32 Versorgungskanal | 71 Überströmleitung |
| 33 Steigkanal | 72 Halterung |
| 34 Versorgungskanal | 73 Schnellverschluß |
| 35 Isoliermantel | 74 Schnellverschraubung |
| 36 Antriebswelle | 75 Stickstoffzuleitung |
| 37 Antriebswelle | 76 Schnellverschraubung |
| 38 Topf | 77 Stickstoffableitung |
| 39 Topfboden | |
| 40 Stickstoffleitung | |

**Patentansprüche**

1. Verfahren zum Herstellen einer sauerstoff-freien Atmosphäre beim Löten von elektronischen Bauteilen unter Schutzgas in einer Lötvorrichtung, die eine mehrteilige Tunnelanordnung (1) mit einer eine Löteinrichtung (23) aufweisenden Lötstrecke (27) umfaßt, dadurch gekennzeichnet, daß die Tunnelelemente bei Verwendung eines Schutzgases, welches leichter ist als Luft, derart geneigt angeordnet werden, daß eingedrungene Luft sich an den tieferliegenden Stellen der Tunnelanordnung (1) ansammelt, wobei ein Austrittstunnel (4) in Transportrichtung der elektronischen Bauteile fallend angeordnet ist.

2.  Verfahren nach Anspruch 1, dadurch gekennzeichnet, daß Stickstoff als Schutzgas verwendet wird.

3.  Vorrichtung zur Durchführung des Verfahrens nach Anspruch 1 mit einer mehrteiligen Tunnelanordnung (1), die eine Fördervorrichtung (10) zum Transport der mit den Lötverbindungen zu versehenden Werkstücke durch einen Löttunnel (3) und eine Lötkammer (26) zwischen einem Eintrittstunnel (2) und einem Austrittstunnel (4) umfaßt, wobei ferner eine Einrichtung zum Löten und eine Einrichtung zum Versorgen der Lötkammer mit Schutzgas vorgesehen sind, dadurch gekennzeichnet, daß der Eintrittstunnel (2) und der Austrittstunnel (4) bei Verwendung eines Schutzgases, welches leichter ist als Luft, derart geneigt angeordnet werden, daß eingedrungene Luft sich an den tieferliegenden Stellen der Tunnelanordnung ansammelt, wobei der Austrittstunnel (4) in Transportrichtung der elektronischen Bauteile fallend angeordnet ist.

4.  Vorrichtung nach Anspruch 3, dadurch gekennzeichnet, daß der Löttunnel (3) mit der Fördervorrichtung (10) für die elektronischen Bauteile in Förderrichtung steigend angeordnet ist.

5.  Vorrichtung nach Anspruch 3 und 4, dadurch gekennzeichnet, daß der Eintrittstunnel (2) zum Löttunnel (3) hin fallend angeordnet ist.

6.  Vorrichtung nach einem oder mehreren der vorhergehenden Ansprüche, dadurch gekennzeichnet, daß der Löttunnel (3) flach ist.

7.  Vorrichtung nach einem oder mehreren der vorhergehenden Ansprüche, dadurch gekennzeichnet, daß der Eintrittstunnel (2), der Löttunnel (3), der Austrittstunnel (4) und gegebenenfalls weitere Tunnelabschnitte (5, 6) durch gasdichte, biegsame Bälge (7, 8, 9) miteinander verbunden sind.

8.  Vorrichtung nach einem oder mehreren der vorhergehenden Ansprüche, dadurch gekennzeichnet, daß der Löttunnel (3) eine Bodenöffnung (17) aufweist und daß die Wanne (19) mit dem Lötmittel-Schmelzbad unterhalb des Tunnelbodens (16) der Lötkammer angeordnet ist.

9.  Vorrichtung nach einem oder mehreren der vorhergehenden Ansprüche, dadurch gekennzeichnet, daß die Tunnelanordnung (1) einen rechteckigen Querschnitt mit vergleichsweise geringer Höhe aufweist.

Fig.1

Fig.2

EP 0 440 264 A1

## Fig.3

## Fig.4

# Fig.5

Europäisches
Patentamt

EUROPÄISCHER
RECHERCHENBERICHT

Nummer der Anmeldung

EP 91 10 3311

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | PATENT ABSTRACTS OF JAPAN vol. 6, no. 26 (M-112)(904) 16 Februar 1982, & JP-A-56 144860 (FUJI DENKI SEIZO K.K.) 11 November 1981, * das ganze Dokument * | 1-4 | B 23 K 1/008 // H 05 K 3/34 |
| A,D | DE-U-8 520 254   (SIEMENS AG) * das ganze Dokument * | 1,3,4,8 | |

RECHERCHIERTE
SACHGEBIETE (Int. Cl.5)

B 23 K

Der vorliegende Recherchenbericht wurde für alle Patentansprüche erstellt

| Recherchenort | Abschlußdatum der Recherche | Prüfer |
|---|---|---|
| Den Haag | 12 Juni 91 | ARAN D.D. |

KATEGORIE DER GENANNTEN DOKUMENTE

X : von besonderer Bedeutung allein betrachtet
Y : von besonderer Bedeutung in Verbindung mit einer
 anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder
 nach dem Anmeldedatum veröffentlicht worden ist
D : in der Anmeldung angeführtes Dokument
L : aus anderen Gründen angeführtes Dokument

-------------------------------------------------------

& : Mitglied der gleichen Patentfamilie,
 übereinstimmendes Dokument